(19) Europäisches Patentamt
European Patent Office
Office européen des brevets

(11) Numéro de publication: **0 349 414**
**A1**

(12) **DEMANDE DE BREVET EUROPEEN**

(21) Numéro de dépôt: **89401824.1**

(22) Date de dépôt: **27.06.89**

(51) Int. Cl.5: **C 23 C 16/56**
C 23 C 16/04

(30) Priorité: **28.06.88 FR 8808665**

(43) Date de publication de la demande:
**03.01.90 Bulletin 90/01**

(84) Etats contractants désignés:
**AT CH DE ES GB IT LI NL**

(71) Demandeur: **COMURHEX Société pour la Conversion de l'Uranium en Métal et Hexafluorure**
**Tour Manhattan La Défense 2 6, place de l'Iris**
**F-92400 Courbevoie (FR)**

(72) Inventeur: **Bargues, Michel**
**540 Rue Dunant**
**F-84100 Orange (FR)**

**Boya, Didier**
**3, Avenue de la Libération**
**F-84150 Jonquieres (FR)**

**Gaillard, Dominique**
**6 rue Neuve-Popincourt**
**F-75011 Paris (FR)**

**Netter, Pierre**
**75 rue Stendhal**
**F-30130 Pont Saint-Esprit (FR)**

(74) Mandataire: **Mongrédien, André et al**
**c/o BREVATOME 25, rue de Ponthieu**
**F-75008 Paris (FR)**

(54) **Procédé de remise en forme de pièces localement détériorées, notamment anticathodes.**

(57) Procédé de remise en forme d'une pièce ayant une surface localement détériorée, notamment anticathode consistant à déposer préférentiellement aux endroits détériorés de ladite surface, de préférence par dépôt chimique en phase vapeur, du matériau constituant cette pièce, puis à usiner ladite surface de manière à ce qu'elle recouvre son état d'origine.

EP 0 349 414 A1

**Description**

## PROCEDE DE REMISE EN FORME DE PIECES LOCALEMENT DETERIOREES, NOTAMMENT ANTICATHODES

La présente invention a pour objet un procédé de remise en forme de pièces localement détériorées, notamment anticathodes. Elle s'applique notamment à la remise en forme, par dépôt chimique en phase vapeur, de cibles de pulvérisateurs cathodiques et d'anticathodes pour appareils de radiographie.

Pour réaliser des circuits intégrés, il est nécessaire de déposer plusieurs couches minces (de l'ordre du micromètre) de matériaux aussi divers que l'aluminium, le tungstène, l'oxyde de silicium, le siliciure de tungstène, etc. Ces couches minces peuvent être obtenues par difs techniques : dépôt chimique en phase vapeur (CVD : "Chemical Vapor Deposition" en terminologie anglosaxonne), gravure, pulvérisation cathodique ou dépôt physique ere de tun phase vapeur (PVD : "Physical Vapor Deposition" en terminologie anglosaxonne), ...

Les dispositifs de pulvérisation cathodique utilisent des cibles solides constituées du matériau à déposer en couche mince sur le circuit. Une variante de pulvérisation cathodique, la pulvérisation magnétron, permet des performances améliorées quant à la vitesse de dépôt et la pression de travail (ce qui permet d'obtenir une plus grande pureté des couches).

Sans entrer dans le détail de la description du dispositif de pulvérisation magnétron qui est bien connu, on sait que, pour son bon fonctionnement, on doit créer un champ magnétique intense et parallèle à la cible. La difficulté de création de ce champ conduit à des solutions où le champ est localisé sur la cible. Cette dernière, soumise à un bombardement électronique, s'use suivant la forme d'un sillon qui finit par traverser la cible ; elle est alors inutilisable et une grande quantité de matériaux coûteux constituant la cible est perdue.

Une situation sensiblement analogue apparaît dans les appareils de radiographie où les anticathodes subissent aussi une usure localisée. Ces anticathodes peuvent être réalisées de diverses manières mais elles présentent toujours une surface en tungstène ou en alliage de tungstène et de rhénium. Pour produire des rayons X, on bombarde cette surface par un faisceau d'électrons accélérés très localisé. L'anticathode est en rotation (avec une vitesse angulaire de l'ordre de 10 000 tours/mn) ; le faisceau d'électrons très énergétique fragilise donc la surface en W ou W/Re (par recristallisation partielle) sur un sillon étroit : cette usure finit par rendre l'anticathode inutilisable.

L'invention, objet de la présente demande, propose de remettre en forme de telles pièces coûteuses, détériorées localement, par ajout d'un dépôt de matière constituant ces pièces sélectivement aux endroits usés, et de permettre ainsi leur réutilisation.

De façon plus précise, l'invention concerne un procédé de remise en forme d'une pièce ayant une surface localement détériorée, caractérisé en ce qu'il consiste à :

- déposer préférentiellement aux endroits détériorés de ladite surface, du matériau constituant cette dernière,
- usiner ladite surface de cette pièce de manière à ce qu'elle recouvre son état d'origine.

Les pièces peuvent éventuellement subir un traitement avant le dépôt. Ce traitement peut consister en l'élimination de la partie endommagée de la surface par usinage et rectification puis dégazage par exemple.

De même, après le dépôt et l'usinage de finition, la pièce peut à nouveau subir un dégazage.

Le dépôt peut être effectué selon toute sorte de procédés : dépôt chimique en phase vapeur (CVD), dépôt physique en phase vapeur (PVD), électro-déposition, électrolyse par sels fondus, ...

De manière préférentielle, on utilise le dépôt CVD qui permet d'obtenir la plus grande pureté dans les matériaux déposés pour les vitesses de dépôt les plus élevées.

Le dépôt préférentiel peut être obtenu par chauffage local des endroits détériorés de la surface endommagée. Le dépôt CVD consiste en une réaction chimique (de réduction par exemple) qui ne se produit qu'au-dessus d'une certaine température. En ne chauffant localement que les endroits détériorés, on favorise la sélectivité du dépôt.

Le dépôt préférentiel peut aussi être obtenu par jet des gaz réactifs sélectivement sur les endroits détériorés de la pièce. Le chauffage dans ce cas peut être soit global soit sélectif et dans ce dernier cas les deux effets de sélection s'ajoutent pour une meilleure efficacité.

Le procédé selon l'invention, allié à la technologie CVD, permet de remettre en forme de façon particulièrement efficace des cibles dont le matériau constitutif est en métal réfractaire (du tungstène (W), du molybdène (Mo), du tantale (Ta), du titane (Ti) par exemple) ou en siliciure ($WSi_2$, $MoSi_2$, $TaSi_2$, $TiSi_2$, ...) en encore en alliage de métaux réfractaires (WTi ...). Il va de soi que le procédé ne se limite pas à ces matériaux.

### Exemples

1. Remise en forme d'une cible de pulvérisateur cathodique en tungstène (W).

- Caractéristiques de la détérioration :

La détérioration résulte d'une usure le long d'un sillon sur un rayon de la cible pour les cibles circulaires ou sur un segment de droite pour les cibles rectangulaires.

- Caractéristiques du dépôt CVD :

Les pièces sont chauffées par induction grâce à un inducteur à spires. Les gaz arrivent à proximité de la pièce à revêtir en régime laminaire.

On utilise couramment l'un des trois types de réactions suivantes :

$$\text{réduction : } WF_6 + 3H_2 \longrightarrow W\downarrow + 6HF$$

$$\text{dissociation : } 6WF_5 \rightleftharpoons W\downarrow + 5WF_6$$

$$\text{décomposition thermique : } W(CO)_6 \longrightarrow W\downarrow + 6CO$$

La pression peut être comprise entre 0,1 mbar et la pression atmosphérique. On utilise 10 mbars.

La température peut être comprise entre 300 et 2000°C. On utilise 800°C.

- Type d'usinage de finition :

Elimination de la rugosité de surface par rectification de la face de dépôt.

La cible remise en forme par le procédé selon l'invention présente les mêmes caractéristiques qu'une cible neuve, et une qualité équivalente. Des dépôts de 99,995 % de pureté sont possibles.

2. Remise en forme d'une anticathode en frittage mixe W-Re provenant d'un appareil de radiographie.

- Caractéristique de la détérioration :

La détérioration est due à une recristallisation de la couche active de W ou W/Re ou Mo sur une épaisseur variant de 100 à 350 micromètres environ. La recristallisation se caractérise par un grossissement important des grains du matériau et par l'apparition de fissures qui diminuent le rendement de l'anticathode.

- Opérations préliminaires :

- élimination de la partie endommagée (on creuse le sillon sur une profondeur de 400 microns environ) par usinage et rectification.

- dégazage sommaire de la pièce sous un vide secondaire à une température comprise entre 1000 et 2500°C. On extrait les impuretés volatiles provenant du substrat initial.

Les caractéristiques du dépôt sont identiques à celles de l'exemple 1. Le matériau support de la réaction est du W-Re.

- Rectification de la surface.

Opération supplémentaire : dégazage afin d'obtenir une plus grande pureté du matériau et d'extraire les impuretés volatiles ayant été piégées lors de l'usinage.

Ce cycle d'opérations reste très économique par rapport au coût d'une nouvelle pièce. Le procédé selon l'invention permet donc la réutilisation de pièces coûteuses actuellement destinées au rebut.

**Revendications**

1. Procédé de remise en forme d'une pièce ayant une surface localement détériorée, caractérisé en ce qu'il consiste à :

- déposer préférentiellement aux endroits détériorés de ladite surface, du matériau constituant cette dernière,

- usiner ladite surface de cette pièce de manière à ce qu'elle recouvre son état d'origine.

2. Procédé de remise en forme de pièce selon la revendication 1, caractérisé en ce que le dépôt est du type dépôt chimique en phase vapeur.

3. Procédé de remise en forme selon les revendications 1 et 2, caractérisé en ce que le dépôt préférentiel s'obtient par chauffage local des endroits détériorés de ladite surface.

4. Procédé de remise en forme selon les revendications 1 à 3, caractérisé en ce que le dépôt préférentiel s'obtient par jet des gaz réactifs sélectivement sur les endroits détériorés de ladite surface.

Office européen des brevets

# RAPPORT DE RECHERCHE EUROPEENNE

Numero de la demande

EP 89 40 1824

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | GB-A-2 107 628 (ROLLS-ROYCE)<br>* Résumé; page 2, lignes 22-24 * | 1 | C 23 C 16/56<br>C 23 C 16/04 |
| A | EP-A-0 172 604 (GOULD INC.)<br>* Revendications 24,26 * | 1-3 | |
| A | US-A-4 533 449 (PERKIN ELMER)<br>* Résumé * | 4 | |
| | | | **DOMAINES TECHNIQUES RECHERCHES (Int. Cl.5)** |
| | | | C 23 C<br>B 23 P |

Le présent rapport a été établi pour toutes les revendications

| Lieu de la recherche | Date d'achèvement de la recherche | Examinateur |
|---|---|---|
| LA HAYE | 05-10-1989 | PATTERSON A.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)